# EUROPÄISCHE PATENTSCHRIFT

(11) **EP 1 184 482 B1**
(45) Veröffentlichungstag und Bekanntmachung des Hinweises auf die Patenterteilung: **27.10.2004**
(21) Anmeldenummer: 01119883.5
(22) Anmeldetag: 17.08.2001
(51) Int. Cl.: C23C 14/20, C23C 14/02

(54) **Verfahren zur Herstellung eines metallisierten Polymers**
Method for producing a metallized polymer
Procédé pour préparer un polymère métallisé

(30) Priorität: 01.09.2000 DE 10043513
(43) Veröffentlichungstag der Anmeldung: 06.03.2002
(73) Patentinhaber: Sympatex Technologies GmbH, 42103 Wuppertal (DE)
(72) Erfinder: Van De Ven, Henricus Joannes Maria, 6825 CT Arnhem (NL); Kopp, Karl Walter, 64354 Reinheim (DE); Spijkers, Josef Christiaan, 42781 Haan (DE)
(74) Vertreter: Muth, Arno, Dipl.-Ing.

(56) Entgegenhaltungen:
- EP-A- 0 443 696
- DE-A- 4 322 512
- US-A- 4 783 243
- DATABASE WPI Section Ch, Week 198723 Derwent Publications Ltd., London, GB; Class A32, AN 1987-160115 XP002183997 -& JP 62 094334 A (DAIICHI LACE KK), 30. April 1987 (1987-04-30)
- PATENT ABSTRACTS OF JAPAN vol. 012, no. 176 (C-498), 25. Mai 1988 (1988-05-25) & JP 62 282078 A (TOPPAN PRINTING CO LTD), 7. Dezember 1987 (1987-12-07)
- PATENT ABSTRACTS OF JAPAN vol. 004, no. 159 (C-030), 6. November 1980 (1980-11-06) & JP 55 104947 A (SANYO ELECTRIC CO LTD;OTHERS: 01), 11. August 1980 (1980-08-11)

## Beschreibung

Die vorliegende Erfindung betrifft ein wasserdampfdurchlässiges wasserdichtes und wärmereflektierendes flächiges Composite, ein Verfahren zu seiner Herstellung und seine Verwendung.

Wasserdampfdurchlässige wasserdichte und wärmreflektierende Composites aus einer Metallschicht und einer mikroporösen Membran sind bekannt. So beschreibt die US 5 955 175 ein textiles Material, das durch Metallisierung einer mikroporösen Membran hergestellt wird. Die Metallisierung bewirkt eine Reflexion von Wärmestrahlung. Das Metall bildet eine diskontinuierliche Schicht auf der Oberfläche und auf den an die Oberfläche angrenzenden Porenwänden der mikroporösen Membran. Verglichen mit der Größe von H₂O-Molekülen sind die Poren der mikroporösen Membran auch im metallisierten Zustand sehr groß, so dass die Wasserdampfdurchlässigkeit der mikroporösen Membran auch nach ihrer Metallisierung erhalten bleibt.

DE 43 22 512 A offenbart, Polymersubstrate zur Verbesserung der Metalladhäsion in einem sauerstoffaltigen Plasma unter Normaldruck oder unter Vakuum vorzubehandeln und anschließend bei Niederdruck durch Aufdampfen zu metallisieren. Als Substrate werden Reflektorgehäuse genannt, die naturgemäß porenfrei und wasserdampfundurchlässig sind.

Wasserdampfdurchlässige wasserdichte und wärmereflektierende Composites aus einer Metallschicht und einer porenfreien Membran, bzw. aus einem porenfreien Substrat, sind bislang nicht bekannt. Versucht man, die in US 5 955 175 beschriebene Metallisierung einer mikroporösen Membran mit einer porenfreien Membran, so stellt man fest, dass die Haftung zwischen Metallschicht und porenfreier Membran sehr schlecht ist, d.h., dass die Metallschicht bereits nach kurzem Gebrauch abblättert.
JP 62 094 334 A offenbart ein Verfahren, bei dem ein Polyurethanfilm, d.h. eine porenfreie, wasserdampfdurchlässige und hydrophile Folie, mit einer Metallschicht versehen wird. Jedoch schreibt JP 62 094 334 A zwingend vor, dass in die Metallschicht Risse eingeführt werden müssen, damit der Composite wasserdampfdurchlässig wird. Zusätzlich muß zur Verbesserung der Haftfestigkeit der Metallschicht eine weitere Polymerschicht aufgetragen werden.
Daher stellt sich die vorliegende Erfindung die Aufgabe, ein einfacheres Verfahren zur Herstellung eines akzeptabel wasserdampfdurchlässigen, wasserdichten und wärmereflektierenden Composites aus einer Metallschicht und einem porenfreien Substrat und ein derartiges Composite zur Verfügung zu stellen.

Diese Aufgabe wird zum einen gelöst durch ein Verfahren zur Herstellung eines wasserdampfdurchlässigen, wasserdichten, wärmereflektierenden flächigen Composites, umfassend eine kontinuierliche Metallschicht und eine porenfreie wasserdampfdurchlässige wasserdichte hydrophile Polyetherester-, Polyetheramid- oder Polyetherurethan-Folie, wobei die Metallschicht eine der Folie zugewandte Oberfläche und eine von der Folie abgewandte Oberfläche aufweist und wobei die Folie eine der Metallschicht zugewandte Oberfläche und eine von der Metallschicht abgewandten Oberfläche aufweist, umfassend zumindest die Schritte
a) Vorlegen der Folie,
b) Vorreinigen der Folie durch Plasmabehandlung in Sauerstoff oder in einem sauerstoffhaltigen Gas und
c) Aufbringen der Metallschicht auf die der Metallschicht zugewandte Oberfläche der Folie in einer Dicke von 10 bis 200 nm.

Die mit dem erfindungsgemäßen Verfahren hergestellten Composites zeigen eine Tapetest-beständige Haftung zwischen Metallschicht und Substrat.

Wie bereits erwähnt, gewährleisten im Fall der bekannten metallisierten mikroporösen Membran die im Vergleich zu H₂O-Molekülen sehr großen Poren dieser Membran deren Wasserdampfdurchlässigkeit. Bei der Metallisierung eines porenfreien wasserdampfdurchlässigen und wasserdichten Substrats musste jedoch erwartet werden, dass eine kontinuierliche Metallschicht auf dem Substrat entsteht, die nicht mehr wasserdampfdurchlässig ist. Dies gilt umsomehr, da es aus dem Bereich der Verpackungsfolien bekannt ist, Folien mit einer dünnen Metallschicht zu versehen, die, wie in JP-A-11 279 306 beschrieben, bereits bei einer Dicke von etwa 10 nm eine Dampfbarriere bildet.

Daher muss es überraschen, dass in Gestalt des erfindungsgemäßen Verfahrens ein Composite aus einer Metallschicht und einer porenfreien Folie zugänglich wird, das nicht nur wärmereflektierend sondern auch in nennenswertem Maße wasserdampfdurchlässig ist. Noch mehr muss es überraschen, dass mit dem erfindungsgemäßen Verfahren Composites zur Verfügung gestellt werden können, die selbst bei 100 %iger Wärmereflexion eine Wasserdampfdurchlässigkeit zeigen, die im Vergleich zur nicht metallisierten porenfreien Folie nur wenig verringert ist.

Die in Schritt a) vorgelegte Folie ist in einer weiteren bevorzugten Ausführungsform der Erfindung auf der Seite, die von der in Schritt c) aufzubringenden Metallschicht abgewandt ist, an ein textiles Flächengebilde wie z.B. ein Gewebe, ein Vliesstoff oder eine Wirkware gebunden.

Die in Schritt a) vorgelegte Folie ist in einer bevorzugten Ausführungsform der Erfindung auf der Seite, die der in Schritt c) aufzubringenden Metallschicht zugewandt ist, an ein textiles Flächengebilde wie z.B. ein Gewebe, ein Vliesstoff oder eine Wirkware gebunden, dessen Fäden in Abständen angeordnet sind. Der Abstand der Fäden stellt sicher, dass ein Teil der Folienoberfläche für die Schritte b) und c) zugänglich ist.

Erfindungsgemäß muss vor dem Aufbringen der Metallschicht in Schritt c) die Folie in Schritt b) vorgereinigt werden, wobei vorzugsweise die Vorreinigung auf der Seite der Folie durchgeführt wird, die der in Schritt c) aufzubringenden Metallschicht zugewandt ist.

Zur Vorreinigung der Folie hat sich für das erfindungsgemäße Verfahren eine Plasmabehandlung in Sauerstoff als geeignet erwiesen, um eine gute Haftung zwischen Metall und Folie zu erreichen, weshalb diese Plasmabehandlung im erfindungsgemäßen Verfahren eingesetzt wird, wobei die Plasmabehandlung z. B. im Vakuum, vorzugsweise bei einem Druck von 1 mbar bis 0,001 mbar und besonders bevorzugt bei einem Druck von 0,01 mbar bis 0,03 mbar, durchgeführt wird.

Im erfindungsgemäßen Verfahren wird zur Vorreinigung der Folie eine Plasmabehandlung in einem sauerstoffhaltigen Gas eingesetzt, wobei als sauerstoffhaltiges Gas eine Mischung aus 10 bis 50 Vol.-% Sauerstoff und 90 bis 10 Vol.-% Stickstoff besonders bevorzugt eingesetzt wird. Ganz besonders bevorzugt wird erfindungsgemäß Luft als sauerstoffhaltiges Gas eingesetzt, weil mit Luft bereits nach kurzer Plasmadauer die Folie derart gut vorgereinigt ist, dass die in Schritt c) aufzubringende Metallschicht Tapetest-beständig an der Folie haftet. Tapetest-Beständigkeit bedeutet im Rahmen der vorliegenden Erfindung, dass beim Versuch, einen auf die Metallschicht der Folie geklebten Tesa®-Filmstreifen abzuziehen, entweder die Folie zerreißt oder der Tesa®-Filmstreifen ohne Zerstörung der Folie abgezogen werden kann und dabei kein Metall mitreißt.

In einer bevorzugten Ausführungsform des erfindungsgemäßen Verfahrens wird die Plasmabehandlung in Luft, besonders bevorzugt bei Normaldruck, d.h. als Corona-Entladung, durchgeführt. Der Vorteil dieser Ausführungsform besteht darin, dass die Erzeugung eines Vakuums entfällt. Jedoch können Fremdgase, die sich in der Luft des Labors oder der Produktionshalle befinden, die Vorreinigung stören.

Deshalb wird in einer weiteren besonders bevorzugten Ausführungsform des erfindungsgemäßen Verfahrens die Plasmabehandlung in einer Mischung aus 10 bis 50 Vol.-% Sauerstoff und 90 bis 50 Vol.-% Stickstoff, bzw. in Luft im Vakuum durchgeführt. Dadurch wird das Eindringen von Fremdgasen in das Plasma verhindert und somit gewährleistet, dass die Plasmabehandlung tatsächlich nur in einem definierten Plasmagas stattfindet.

Bevorzugt beträgt das Vakuum 1 mbar bis 0,001 mbar und besonders bevorzugt 0,01 mbar bis 0,03 mbar, weil in diesen Bereichen eine besonders kurze Vorbehandlung möglich ist.

Das Aufbringen der Metallschicht in Schritt c) des erfindungsgemäßen Verfahrens geschieht vorzugsweise mittels Physical Vapor Deposition (PVD). Diese Beschichtungstechnik ist bekannt und u.a. in L. Holland, "Vacuum deposition of thin films", Chapman and Hall, London (1966) beschrieben.

Vorzugsweise wird im erfindungsgemäßen Verfahren die Metallschicht in einer Dicke von 30 bis 180 nm aufgebracht.

Grundsätzlich kann im erfindungsgemäßen Verfahren zum Aufbringen der Metallchicht jedes Metall eingesetzt werden, dass mit PVD prozessierbar ist. Bevorzugt wird im erfindungsgemäßen Verfahren als Metallschicht eine Al-, Cu-, Au- oder Ag-Schicht oder eine Schicht aus einer AgGe-, CuZn-, CuSn-, CuAg- oder CuAgSn-Legierung aufgebracht, wobei die Schichten aus den Legierungen eine höhere Korrosionsbeständigkeit aufweisen als die Schichten aus den reinen Metallen.

Um die Metallschicht vor Oxidation zu schützen, wird in einer bevorzugten Ausführungsform des erfindungsgemäßen Verfahrens nach Schritt c) auf der Metallschicht eine Schutzschicht aufgebracht, wobei eine Schutzschicht aus einem vemetzten Polyurethan besonders bevorzugt ist.

Die der Erfindung zugrunde liegende Aufgabe wird des weiteren gelöst durch ein wasserdampfdurchlässiges wasserdichtes wärmereflektierendes flächiges Composite umfassend eine Metallschicht und eine porenfreie wasserdampfdurchlässige wasserdichte hydrophile Polyetherester-, Polyetheramid- oder Polyetherurethan-Folie, die nach dem vorstehend beschriebenen erfindungsgemäßen Verfahren herstellbar ist.

Die der Erfindung zugrunde liegende Aufgabe wird ferner gelöst durch ein wasserdampfdurchlässiges wasserdichtes wärmereflektierendes flächiges Composite umfassend eine Metallschicht und eine porenfreie wasserdampfdurchlässige wasserdichte hydrophile Polyetherester-, Polyetheramid- oder Polyetherurethan-Folie, wobei die Metallschicht eine der Folie zugewandte Oberfläche und eine von der Folie abgewandte Oberfläche aufweist, die Folie eine der Metallschicht zugewandte Oberfläche und eine von der Metallschicht abgewandten Oberfläche aufweist und wobei die Metallschicht zumindest überwiegend auf der Folienoberfläche Tapetest-beständig haftet.

Dass die Metallschicht zumindest überwiegend auf der Folienoberfläche Tapetest-beständig haftet, bedeutet im Rahmen der vorliegenden Erfindung, dass die Metallschicht auf annähernd der gesamten Folienoberfläche, die der Metallschicht zugewandt ist, Tapetest-beständig haftet.

In einer bevorzugten Ausführungsform des erfindungsgemäßen Composites haftet die Metallschicht auf der gesamten Folienoberfläche Tapetest-beständig.

In einer weiteren bevorzugten Ausführungsform des erfindungsgemäßen Composites ist die Folie auf ihrer von der Metallschicht abgewandten Oberfläche an ein textiles Flächengebilde, z.B. an ein Gewebe, an einen Vliesstoff oder an eine Wirkware, gebunden.

Tapetest-Beständigkeit bedeutet hierbei, dass beim Versuch, einen auf die metallisierte Seite des Composites geklebten Tesa®-Filmstreifen abzuziehen, entweder die Folie zerreißt oder der Tesa®-Filmstreifen ohne Zerstörung der Folie abgezogen werden kann und dabei kein Metall mitreißt.

In einer bevorzugten Ausführungsform des erfindungsgemäßen Composites ist die Folie auf ihrer der Metallschicht zugewandten Oberfläche an ein textiles Flächengebilde gebunden, dessen Fäden in Abständen angeordnet sind, wobei die Metallschicht sowohl an den Fäden als auch zwischen den Fäden an der Folienoberfläche Tapetest-beständig haftet.

Tapetest-Beständigkeit bedeutet hierbei, dass beim Versuch, einen auf die metallisierte Seite des Composites geklebten Tesa®-Filmstreifen abzuziehen, der Tesa®-Filmstreifen ohne Zerstörung der Folie abgezogen werden kann und dabei kein Metall mitreißt.

Vorzugsweise ist die Metallschicht des erfindungsgemäßen Composites eine Al-, Cu-, Au- oder eine Ag-Schicht oder eine Schicht aus einer AgGe-, CuZn-, CuSn-, CuAg- oder CuAgSn-Legierung.

Die Metallschicht des erfindungsgemäßen Composites hat bevorzugt eine Dicke von 10 bis 200 nm, besonders bevorzugt von 30 bis 180 nm, weil in diesen Bereichen die erfindungsgemäßen Composites in hohem Maße wasserdampfdurchlässig und wärmereflektierend sind.

In einer bevorzugten Ausführungsform des erfindungsgemäßen Composites ist die Metallschicht auf ihrer von der Folie abgewandten Oberfläche mit einer Schutzschicht versehen, wobei als Schutzschicht ein vernetztes Polyurethan besonders bevorzugt ist.

Das erfindungsgemäße Composite eignet sich vorteilhaft zur Herstellung von Kleidung, die nicht nur wasserdicht und wasserdampfdurchlässig ist, sondern zusätzlich dem Träger alle Schutzfunktionen bietet, die durch die Metallschicht möglich werden, wie z.B. Schutz vor Wärmeverlust und IR-Enttamung, Schutz vor Hitze, UV-Strahlung und Elektrosmog und Schutz vor elektrischer Aufladung. Zudem verbessert die Metallschicht den ästhetischen Eindruck für Anwendungen, in denen ein Metalic-Look erwünscht ist und ermöglicht wegen der Wärmeleitfähigkeit von Metall einen Temperaturausgleich über die Fläche des Composites.

Eine Ausführungsform der Erfindung, die ein besonders hohes Maß an thermischer Isolation bewirkt und deshalb bevorzugt ist, bildet ein Composite, das nach dem vorstehend beschriebenen erfindungsgemäßen Verfahren herstellbar ist oder ein erfindungsgemäßes Composite der vorstehend beschriebenen Art, die dadurch gekennzeichnet sind, dass auf der von der Folie abgewandten Oberfläche der Metallschicht oder auf der Schutzschicht ein textiles Flächengebilde mit einer der Metallschicht oder der Schutzschicht zugewandten Oberfläche und mit einer von der Metallschicht oder von den Schutzschicht abgewandten Oberfläche gelegt ist und gegebenenfalls auf dem textilen Flächengebilde auf seiner von der Metallschicht oder von der Schutzschicht abgewandten Oberfläche ein Textilstoff gelegt ist, wobei das textile Flächengebilde aus solchen Materialien ausgewählt ist, die konvektionsunterdrükkend wirken und so ausgebildet sind, dass die der Metallschicht oder der Schutzschicht zugewandte Oberfläche des textilen Flächengebildes nur einen Teil der Oberfläche der Metallschicht oder der Schutzschicht kontaktiert.

Die Erfindung wird im folgenden Beispiel weiter erläutert.

### Beispiel

In einem Rezipienten mit einem Volumen von 40 Litern wird eine 10 µm dicke Polyetheresterfolie, die unter dem Namen SYMPATEX® kommerziell erhältlich ist, mit Klebeband an einem Probehalter befestigt, der sich 20 cm über einer mit Aluminium beladenen Wolframwendel befindet. Die Fläche der Folie beträgt 15 x 17 cm. Der Rezipient wird auf 0,00003 mbar abgepumpt. Danach wird zur Vorreinigung eine Plasmabehandlung mit Luft als reaktivem Gas durchgeführt. Zu diesem Zweck wird Luft bei einem Druck von 0,02 mbar in den Rezipienten geleitet und ein Plasma gezündet. Das Plasma hat eine Frequenz von 50 Hz und eine Leistung von etwa 30 W. Man lässt das Plasma 60 Sekunden auf die Folie einwirken. Danach wird zur Metallisierung der vorgereinigten Folie der Rezipient auf 0,00003 mbar abgepumpt und durch elektrisches Erhitzen der mit Aluminium beladenen Wolframwendel das Aluminium verdampft, wobei sich eine Al-Schicht auf der Polyetherester-Folie bildet. Die Dicke der Al-Schicht ist von der Dauer der Al-Bedampfung abhängig.

Die Bestimmung der Dicke der Al-Schicht erfolgt mit ICP-MS (Inductive Coupled Plasma - Mass Spectroscopy). Dabei wird das Aluminium auf einer definierten Fläche der metallisierten Folie in Salzsäure aufgelöst. Die Lösung wird als Aerosol, mit Argon als Trägergas in eine Plasmafackel eindosiert, wodurch im Plasmagas lonen erzeugt werden. Ein aliquoter Anteil des Plasmagases wird einem Massenspektrometer zugeführt. Im Massenspektrometer werden die im Plasmagas enthaltenen Ionen nach Masse und Ladung getrennt und in einem nachgeschalteten Detektor quantifiziert. Durch Vergleich mit Kontrollstandards wird die Dicke der Metallschicht bestimmt. Es wurden Composites mit einer Aluminiumdicke von 15 ± 4 nm, 60 ± 4 nm und 150 ± 13 nm hergestellt (s. Tabelle). Dazu wurden die Sympatex® -Folien etwa 8 Sekunden, 30 Sekunden und 75 Sekunden mit Al bedampft.

Zur Bestimmung der Haftung zwischen Metallschicht und Folie in den drei Composites wurde der Tapetest durchgeführt. Dazu wurde ein Tesafilm-Streifen auf die Metallschicht geklebt. Beim Versuch, den Tesafilm-Streifen von der Folie abzuziehen, wurde kein Metall abgerissen.

Zur weiteren Bestimmung der Haftung zwischen Metallschicht und Folie in den drei Composites wurden die Composites 45 Minuten lang in 50 °C warmem Wasser gelagert. Nach Herausnehmen der Composites aus dem Wasser wurde mit einem Tuch über die metallisierte Seite der Composites mit leichtem Druck gestrichen. Dabei ergab sich eine fehlerfreie Haftung der Aluminiumschicht auf der Folie. Danach wurde die metallisierte Seite des Composites getrocknet und ein Tesafilm Streifen auf die metallisierte Seite geklebt. Beim Versuch, den Tesafilm-Streifen von der Folie abzuziehen, wurde kein Metall abgerissen.

Die Aluminiumdicke (d_{Al}), die Wasserdampfdurchlässigkeit (WDD), gemessen nach ASTM E 96-66, Methode B mit der Modifikation T_{Wasser} = 30 °C, T_{Luft} = 20 °C, relative Feuchte = 60 % und Luftfluss 2 m/s und die IR-Reflexion (R_{IR}), gemessen im Wellenlängenbereich von 2,5 bis 10 µm, der metallisierten Sympatex® -Folien A, B und C sind in der folgenden Tabelle dargestellt, wobei die für die Dicke angegebene Fehlerbreite den maximalen Fehler aus zwei Messungen darstellt.

| Probe | d_{Al} (nm) | WDD (g/m²•24h) | R_{IR} (%) |
|---|---|---|---|
| Sympatex® -Folie | 0 | 3000 | 10 |
| metallisierte Sympatex® -Folie A | 15 ± 4 | 2700 | 86 |
| metallisierte Sympatex® -Folie B | 60 ± 4 | 2600 | 97,5 |
| metallisierte Sympatex® -Folie C | 150 ± 13 | 2200 | 100 |

Die Tabelle zeigt, dass die metallisierte Sympatex®-Folie C bei 100 %iger IR-Reflexion noch eine Wasserdampfdurchlässigkeit von 2200 g/m² • 24h zeigt, die im Vergleich zur Wasserdampfdurchlässigkeit der Sympatex®-Folie von 3000 g/m² • 24h nur um etwa ein Viertel verringert ist.

## Patentansprüche

1. Verfahren zur Herstellung eines wasserdampfdurchlässigen wasserdichten wärmereflektierenden flächigen Composites umfassend eine kontinuierliche Metallschicht und eine porenfreie wasserdampfdurchlässige wasserdichte hydrophile Polyetherester-, Polyetheramid- oder Polyetherurethan-Folie, wobei die Metallschicht eine der Folie zugewandte Oberfläche und eine von der Folie abgewandte Oberfläche aufweist und wobei die Folie eine der Metallschicht zugewandte und eine von der Metallschicht abgewandte Oberfläche aufweist, umfassend zumindest die Schritte
a) Vorlegen der Folie,
b) Vorreinigen der Folie durch Plasmabehandlung in Sauerstoff oder in einem sauerstoffhaltigem Gas und
c) Aufbringen der Metallschicht auf die der Metallschicht zugewandte Oberfläche der Folie in einer Dicke von 10 bis 200 nm.

2. Verfahren nach Anspruch 1, **dadurch gekennzeichnet, dass** die in Schritt a) vorgelegte Folie auf der Seite, die von der in Schritt c) aufzubringenden Metallschicht abgewandt ist, an ein textiles Flächengebilde gebunden ist.

3. Verfahren nach Anspruch 1, **dadurch gekennzeichnet, dass** die in Schritt a) vorgelegte Folie auf der Seite, die der in Schritt c) aufzubringenden Metallschicht zugewandt ist, an ein textiles Flächengebilde gebunden ist, dessen Fäden in Abständen angeordnet sind.

4. Verfahren nach Anspruch 1 bis 3, **dadurch gekennzeichnet, dass** in Schritt b) die Vorreinigung auf der Seite der Folie durchgeführt wird, die der in Schritt c) aufzubringenden Metallschicht zugewandt ist.

5. Verfahren nach Anspruch 1 bis 4, **dadurch gekennzeichnet, dass** das sauerstoffhaltige Gas eine Mischung aus 10 bis 50 Vol.-% Sauerstoff und 90 bis 10 Vol.-% Stickstoff ist.

6. Verfahren nach Anspruch 5, **dadurch gekennzeichnet, dass** als sauerstoffhaltiges Gas Luft eingesetzt wird.

7. Verfahren nach Anspruch 6, **dadurch gekennzeichnet, dass** die Plasmabehandlung bei Normaldruck durchgeführt wird.

8. Verfahren nach Anspruch 6, **dadurch gekennzeichnet, dass** die Plasmabehandlung in einem Vakuum durchgeführt wird.

9. Verfahren nach Anspruch 8, **dadurch gekennzeichnet, dass** das Vakuum 1 mbar bis 0,001 mbar beträgt.

10. Verfahren nach Anspruch 9, **dadurch gekennzeichnet, dass** das Vakuum 0,01 mbar bis 0,03 mbar beträgt.

11. Verfahren nach Anspruch 1 bis 10, **dadurch gekennzeichnet, dass** in Schritt c) das Aufbringen der Metallschicht mittels Physical Vapor Deposition geschieht.

12. Verfahren nach Anspruch 1 bis 11, **dadurch gekennzeichnet, dass** in Schritt c) die Metallschicht in einer Dicke von 30 bis 180 nm aufgebracht wird.

13. Verfahren nach Anspruch 1 bis 12, **dadurch gekennzeichnet, dass** als Metallschicht eine Al-, Cu-, Au- oder eine Ag-Schicht oder eine Schicht aus einer AgGe-, CuZn-, CuSn-, CuAg- oder CuAgSn-Legierung aufgebracht wird.

14. Verfahren nach Anspruch 1 bis 13, **dadurch gekennzeichnet, dass** nach Schritt c) auf der Metallschicht eine Schutzschicht aufgebracht wird.

15. Verfahren nach Anspruch 14, **dadurch gekennzeichnet, dass** als Schutzschicht ein vernetztes Polyurethan aufgebracht wird.

16. Wasserdampfdurchlässiges wasserdichtes wärmereflektierendes flächiges Composite umfassend eine Metallschicht und eine porenfreie wasserdampfdurchlässige wasserdichte hydrophile Polyetherester-, Polyetheramid- oder Polyetherurethan-Folie herstellbar nach einem Verfahren gemäß einem oder mehreren der Ansprüche 1 bis 15.

17. Composite nach Anspruch 16, **dadurch gekennzeichnet, dass** die Folie auf ihrer von der Metallschicht abgewandten Oberfläche an ein textiles Flächengebilde gebunden ist.

18. Composite nach Anspruch 16 oder 17, **dadurch gekennzeichnet, dass** die Metallschicht eine Al-, Cu-, Au- oder eine Ag-Schicht oder eine Schicht aus einer AgGe-, CuZn-, CuSn-, CuAg- oder CuAgSn-Legierung ist.

19. Composite nach Anspruch 16 bis 18, **dadurch gekennzeichnet, dass** die Metallschicht eine Dicke von 10 bis 200 nm hat.

20. Composite nach Anspruch 16 bis 19, **dadurch gekennzeichnet, dass** die Metallschicht eine Dicke von 30 bis 180 nm hat.

21. Composite nach einem oder mehreren der Ansprüche 16 bis 20, **dadurch gekennzeichnet, dass** die Metallschicht auf ihrer von der Folie abgewandten Oberfläche mit einer Schutzschicht versehen ist.

22. Composite nach Anspruch 21, **dadurch gekennzeichnet, dass** die Schutzschicht ein vernetztes Polyurethan ist.

23. Composite nach Anspruch 16 bis 22, **dadurch gekennzeichnet, dass** auf der von der Folie abgewandten Oberfläche der Metallschicht oder auf der Schutzschicht ein textiles Flächengebilde mit einer der Metallschicht oder der Schutzschicht zugewandten Oberfläche und mit einer von der Metallschicht oder von der Schutzschicht abgewandten Oberfläche gelegt ist und gegebenenfalls auf dem textilen Flächengebilde auf seiner von der Metallschicht oder von der Schutzschicht abgewandten Oberfläche ein Textilstoff gelegt ist, wobei das textile Flächengebilde aus solchen Materialien ausgewählt ist, die konvektionsunterdrückend wirken und so ausgebildet sind, dass die der Metallschicht oder der Schutzschicht zugewandte Oberfläche des textilen Flächengebildes nur einen Teil der Oberfläche der Metallschicht oder der Schutzschicht kontaktiert.

## Claims

1. Process for manufacturing a water-vapor-permeable, watertight, heat-reflecting flat composite comprising a continuous metal layer and a nonporous, water-vapor-permeable, watertight, hydrophilic film of polyether ester, polyether amide, or polyether urethane, wherein the metal layer has a surface facing the film and a surface facing away from the film, and wherein the film has a surface facing the metal layer and a surface facing away from the metal layer, comprising at least the following steps:
a) readying the film
b) pre-cleaning the film using plasma treatment in oxygen or a gas containing oxygen,and
c) applying the metal layer with a thickness of 10 to 200 nm to the film surface facing the metal layer.

2. Process according to Claim 1, **characterized in that** the film readied in step a) is joined to a textile fabric on the side facing away from the metal layer to be applied in step c).

3. Process according to Claim 1, **characterized in that** the film readied in step a) is joined to a textile fabric on the side facing the metal layer to be applied in step c), the threads of the textile fabric being spaced apart.

4. Process according to Claims 1 to 3, **characterized in that** the pre-cleaning in step b) is conducted on the side of the film facing the metal layer to be applied in step c).

5. Process according to Claims 1 to 4, **characterized in that** the gas containing oxygen is a mixture of 10 to 50% oxygen by volume and 90 to 10% nitrogen by volume.

6. Process according to Claim 5, **characterized in that** air is used as the gas containing oxygen.

7. Process according to Claim 6, **characterized in that** the plasma treatment is conducted at atmospheric pressure.

8. Process according to Claim 6, **characterized in that** the plasma treatment is conducted in a vacuum.

9. Process according to Claim 8, **characterized in that** the vacuum is 1 mbar to 0.001 mbar.

10. Process according to Claim 9, **characterized in that** the vacuum is 0.01 mbar to 0.03 mbar.

11. Process according to Clams 1 to 10, **characterized in that** application of the metal layer in step c) is performed by physical vapor deposition.

12. Process according to Claims 1 to 11, **characterized in that** the metal layer in step c) is applied with a thickness of 30 to 180 nm.

13. Process according to Claims 1 to 12, **characterized in that** the metal layer applied is Al, Cu, Au, or Ag or an alloy of AgGe, CuZn, CuSn, CuAg, or CuAgSn.

14. Process according to Claims 1 to 13, **characterized in that** a protective layer is applied to the metal layer after step c).

15. Process according to Claim 14, **characterized in that** a cross-linked polyurethane is applied as the protective layer.

16. Water-vapor-permeable, watertight, heat-reflecting flat composite comprising a metal layer and a nonporous, water-vapor-permeable, watertight, hydrophilic film of polyether ester, polyether amide, or polyether urethane, producible using a process according to one or more of Claims 1 to 15.

17. Composite according to Claim 16, **characterized in that** the film is joined to a textile fabric on the film surface facing away from the metal layer.

18. Composite according to Claim 16 or 17, **characterized in that** the metal layer is Al, Cu, Au, or Ag or an alloy of AgGe, CuZn, CuSn, CuAg, or CuAgSn.

19. Composite according to Claims 16 to 18, **characterized in that** the metal layer has a thickness of 10 to 200 nm.

20. Composite according to Claims 16 to 19, **characterized in that** the metal layer has a thickness of 30 to 180 nm.

21. Composite according to one or more of Claims 16 to 20, **characterized in that** the metal layer has a protective layer on the surface facing away from the film.

22. Composite according to Claim 21, **characterized in that** the protective layer is a cross-linked polyurethane.

23. Composite according to Claims 16 to 22, **characterized in that** a textile fabric with a surface facing the metal or protective layer and a surface facing away from the metal or protective layer has been laid on the protective layer or the surface of the metal facing away from the film and a textile material has possibly been laid on the textile fabric on its side facing away from the metal or protective layer, the textile fabric being selected from materials that act to suppress convection and being fashioned such that the surface of the textile fabric facing the metal or protective layer makes contact with only a portion of the surface of the metal or protective layer.

## Revendications

1. Procédé pour la fabrication d'un composite plat, perméable à la vapeur d'eau et étanche vis-à-vis de l'eau, thermoréfléchissant, qui comprend une couche continue en métal, et un film hydrophile de polyétherester, de polyétheramide ou de polyuréthane perméable à la vapeur d'eau, étanche vis-à-vis de l'eau et dépourvu de pores, la couche métallique présentant une surface tournée vers le film et une surface non tournée vers le film, et le film présentant une surface tournée vers la couche métallique et une surface non tournée vers la surface métallique, lequel procédé comprend au moins les étapes qui consistent à :
a) fabriquer le film,
b) prénettoyer le film par traitement au plasma dans de l'oxygène ou dans un gaz qui contient de l'oxygène, et
c) déposer la couche métallique sur la surface du film tournée vers la couche métallique, sur une épaisseur de 10 à 200 nm.

2. Procédé selon la revendication 1, **caractérisé en ce que** le film produit dans l'étape a) est lié à une structure plate en textile par son côté non tourné vers la couche métallique qui doit être déposée lors de l'étape c).

3. Procédé selon la revendication 1, **caractérisé en ce que** le film produit dans l'étape a) est lié à une structure plate en textile dont les fils sont agencés à distance les uns des autres, par son côté tourné vers la couche métallique qui doit être déposée lors de l'étape c).

4. Procédé selon les revendications 1 à 3, **caractérisé en ce que**, dans l'étape b), le prénettoyage est effectué sur le côté du film qui est tourné vers la couche métallique qui doit être déposée lors de l'étape c).

5. Procédé selon les étapes 1 à 4, **caractérisé en ce que** le gaz qui contient de l'oxygène est un mélange de 10 à 50 % en volume d'oxygène et de 90 à 10 % en volume d'azote.

6. Procédé selon la revendication 5, **caractérisé en ce que** de l'air est utilisé comme gaz qui contient de l'oxygène.

7. Procédé selon la revendication 6, **caractérisé en ce que** le traitement au plasma est effectué sous pression normale.

8. Procédé selon la revendication 6, **caractérisé en ce que** le traitement au plasma est effectué sous vide.

9. Procédé selon la revendication 8, **caractérisé en ce que** le vide est de 1 mbar à 0,001 mbar.

10. Procédé selon la revendication 9, **caractérisé en ce que** le vide est de 0,01 mbar à 0,03 mbar.

11. Procédé selon les revendications 1 à 10, **caractérisé en ce que**, dans l'étape c), on dépose la couche métallique par dépôt physique de vapeur.

12. Procédé selon les revendications 1 à 11, **caractérisé en ce que**, dans l'étape c), la couche métallique est déposée sur une épaisseur comprise entre 30 et 180 nm.

13. Procédé selon les revendications 1 à 12, **caractérisé en ce que** comme couche métallique, on dépose une couche d'Al, de Cu, d'Au ou d'Ag ou une couche en alliage d' AgGe, de CuZn, de CuSn, de CuAg ou de CuAgSn.

14. Procédé selon les revendications 1 à 13, **caractérisé en ce qu'**une couche de protection est déposée sur la couche métallique après l'étape c).

15. Procédé selon l'étape 14, **caractérisé en ce que**, comme couche de protection, on dépose un polyuréthane tissé.

16. Composite plat perméable à la vapeur d'eau et étanche vis-à-vis de l'eau, thermoréfléchissant, qui comprend une couche continue en métal et un film hydrophile de polyétherester, de polyétheramide ou de polyuréthane perméable à la vapeur d'eau, étanche vis-à-vis de l'eau et dépourvu de pores, qui peut être fabriqué selon un procédé selon une ou plusieurs des revendications 1 à 15.

17. Composite selon la revendication 16, **caractérisé en ce que**, sur sa surface tournée vers la couche métallique, le film est lié à une structure plate en textile.

18. Composite selon la revendication 16 ou 17, **caractérisé en ce que** la couche métallique est une couche d'Al, de Cu, d'Au ou d'Ag ou une couche en alliage d'AgGe, de CuZn, de CuSn, de CuAg ou de CuAgSn.

19. Composite selon les revendications 16 à 18, **caractérisé en ce que** la couche métallique a une épaisseur de 10 à 200 nm.

20. Composite selon les revendications 16 à 19, **caractérisé en ce que** la couche métallique a une épaisseur de 30 à 180 nm.

21. Composite selon une ou plusieurs des revendications 16 à 20, **caractérisé en ce que** la couche métallique est pourvue d'une couche de protection sur sa surface non tournée vers le film.

22. Composite selon la revendication 21, caractérisé én ce que la couche de protection est un polyuréthane tissé.

23. Composite selon les revendications 16 à 22, **caractérisé en ce que**, sur la surface de la couche métallique non tournée vers le film ou vers la couche de protection, une structure plate en textile est déposée avec une surface tournée vers la couche métallique ou vers la couche de protection et une surface non tournée vers la couche métallique ou vers la couche de protection et, éventuellement, une matière textile est posée sur la surface de la structure plate en textile non tournée vers la couche métallique ou vers la couche de protection, la structure plate en textile étant sélectionnée parmi des matériaux qui inhibent la convection et qui sont réalisés de telle façon que la surface de la structure plate en textile tournée vers la couche métallique ou vers la couche de protection n'est en contact qu'avec une partie de la surface de la couche métallique ou de la couche de protection.
